# FASCICULE DE BREVET EUROPEEN

(11) **EP 3 766 098 B1**
(45) Date de publication et mention de la délivrance du brevet: **29.04.2026**
(21) Numéro de dépôt: 19718901.2
(22) Date de dépôt: 18.03.2019
(51) Int. Cl.: H01L 23/467

(54) **ENSEMBLE DE PUISSANCE, NOTAMMENT POUR UN AERONEF**
LEISTUNGSMODUL, INSBESONDERE FÜR EIN FLUGZEUG
POWER ASSEMBLY, IN PARTICULAR FOR AN AIRCRAFT

(30) Priorité: 16.03.2018 FR 1852258
(43) Date de publication de la demande: 20.01.2021
(73) Titulaire: Safran Electrical & Power, 31702 Blagnac Cedex (FR)
(72) Inventeur: HEUDE, Sébastien, 31700 BLAGNAC (FR); SALAT, Jacques, 31700 BLAGNAC (FR); POCHET, Rémi, 31702 Blagnac cedex (FR)
(74) Mandataire: Ernest Gutmann - Yves Plasseraud S.A.S.
(86) Numéro de dépôt international: PCT/FR2019/050601
(87) Numéro de publication internationale: WO 2019/175522

(56) Documents cités:
- WO-A1-2013/065427
- WO-A1-2014/092655
- DE-A1- 102016 200 724
- JP-A- 2009 182 313
- US-A- 5 915 463

## Description

### DOMAINE

La présente invention concerne un ensemble de puissance, notamment pour un aéronef.

### CONTEXTE

Un module de puissance comporte des puces électroniques, par exemple en silicium ou en carbure de silicium (SiC) ou en nitrure de gallium (GaN), tels notamment que des transistors de puissance, notamment du type MOSFET, des transistors bipolaires à grille isolée (IGBT, de l'anglais Insulated Gate Bipolar Transistor) ou des diodes. Ces puces tendent à émettre de la chaleur qu'il est nécessaire de pouvoir évacuer puisque de telles puces doivent fonctionner dans une plage de température définie. De tels modules de puissance peuvent équiper des aéronefs et être situés dans des environnements qui sont très exposés à de fortes chaleurs, rendant difficile l'évacuation des calories produites par le module de puissance. De tels modules doivent souvent être logés dans un boitier fermé et isolé du flux d'air servant au refroidissement. Par ailleurs, les modes de fonctionnement de tels modules de puissance sont de plus en plus contraignants, puisqu'il est nécessaire de pouvoir pallier à de fortes densités de puissance à évacuer sur de longues durées et/ou à des pics importants de dissipation thermique, espacés par de courtes durées de repos.

Le document WO2013/065427 divulgue un module de puissance avec un refroidissement par liquide. Le document JP 2016-225530 divulgue un autre ensemble de puissance comportant un module de puissance comportant des puces à refroidir montés sur une semelle fixée à la paroi supérieure d'un boîtier par l'intermédiaire d'une interface thermique. L'interface thermique permet d'assurer un bon contact thermique entre la semelle et la paroi supérieure en compensant les légers écarts de planéité dus notamment aux tolérances de fabrication. Le boîtier délimite un canal comportant une entrée et une sortie de fluide de refroidissement liquide, le fluide de refroidissement circulant dans ledit canal. Des picots cylindriques s'étendent depuis la paroi supérieure du boîtier dans le canal, de manière à former des moyens d'échange thermique.

En fonctionnement, les calories issues du module de puissance sont transférées au fluide de refroidissement par l'intermédiaire de l'interface thermique, de la paroi supérieure et des picots cylindriques.

Un tel refroidissement présente cependant une efficacité réduite. En effet, l'interface thermique forme un isolant thermique, réduisant les échanges thermiques entre la semelle du module de puissance et la paroi supérieure du boîtier. La présence de la paroi supérieure limite également les échanges thermiques et augmente le poids de l'ensemble. Enfin l'utilisation d'un fluide liquide nécessite l'intégration d'équipements tels par exemple qu'une pompe et que des canalisations, et l'intégration de moyens d'étanchéité. L'utilisation de picots cylindriques est, en pratique, difficilement compatible avec l'utilisation de l'air pour assurer le refroidissement.

### RESUME DE L'INVENTION

La présente invention vise à remédier à ces inconvénients, de façon simple, fiable et peu coûteuse.

A cet effet, elle concerne un ensemble de puissance comportant au moins deux modules de puissance comprenant chacun au moins un composant à refroidir, par exemple une puce électronique, monté sur une semelle à partir de laquelle s'étendent des éléments de refroidissement, et un corps creux comportant un canal d'écoulement d'un fluide de refroidissement, chaque module de puissance étant monté sur ledit corps de sorte que les éléments de refroidissement s'étendent au moins en partie dans ledit canal au travers d'une ouverture du corps, au moins un déflecteur étant monté dans ledit canal entre les éléments de refroidissement des deux modules de façon à forcer le fluide de refroidissement à s'écouler dans la zone du canal comportant les éléments de refroidissement.

Les éléments de refroidissement et la semelle forment ainsi une seule et même pièce, de sorte que les calories peuvent être évacuées directement, sans devoir traverser une interface thermique isolante. Par ailleurs, la présence du déflecteur permet de garantir que la totalité du débit d'air traversant le canal sert au refroidissement des éléments de refroidissement des modules. On améliore ainsi les performances de refroidissement du module de puissance. Par ailleurs, un même corps permet le refroidissement simultané de plusieurs modules, ce qui permet de limiter le poids de l'ensemble.

La vitesse d'air peut être adaptée en fonction de la forme et des dimensions du déflecteur.

Les éléments de refroidissement peuvent comporter des ailettes planes ou des picots de refroidissement, par exemple de forme cylindrique ou conique. Bien entendu toute autre forme peut être envisagée.

Les éléments de refroidissement peuvent s'étendre sur toute la hauteur du canal.

Le corps peut comporter une paroi supérieure, une paroi inférieure et deux parois latérales délimitant entre elles le canal.

Le canal peut être rectiligne. Le canal peut comporter une première extrémité formant une entrée d'air et une seconde extrémité formant une sortie d'air.

Les éléments de refroidissement peuvent être parallèles entre eux et peuvent être orientées dans la direction du canal.

La semelle peut comporter une partie supérieure insérée dans l'ouverture du corps, les éléments de refroidissement s'étendant depuis une partie inférieure de la semelle.

La semelle peut comporter une partie supérieure formant un épaulement entourant la partie inférieure de la semelle, la partie supérieure de la semelle venant en appui sur le corps.

La partie supérieure de la semelle peut notamment venir en appui sur la paroi supérieure du corps.

La partie supérieure de la semelle peut être fixée au corps, par exemple par vissage.

La paroi supérieure peut comporter une zone amincie dont l'épaisseur correspond sensiblement à l'épaisseur de la partie inférieure de la semelle.

L'amincissement local de la paroi supérieure permet encore de réduire la masse de l'ensemble.

Le déflecteur peut s'étendre dans la direction du canal et comporte une extrémité amont arrondie ou profilée.

Le terme amont est défini par rapport au sens de circulation du fluide dans le canal.

L'ensemble peut comporter au moins un déflecteur central, disposé entre les éléments de refroidissement d'un premier module de puissance, d'une part, et les éléments de refroidissement d'un deuxième module de puissance, d'autre part, un premier déflecteur latéral situé entre les éléments de refroidissement du premier module de puissance et un premier bord latéral du canal, et un second déflecteur latéral situé entre les éléments de refroidissement du second module de puissance et un second bord latéral du canal.

Le premier déflecteur latéral et le second déflecteur latéral peuvent se présenter chacun sous la forme d'un module de déflection de structure unique, le déflecteur central étant composé de deux modules de déflection adjacents.

Une même structure de module de déflection peut ainsi être utilisée pour réaliser tous les déflecteurs de l'ensemble. Le déflecteur central est alors composé de deux modules de déflection placés de façon symétrique par rapport à l'axe du canal et côte à côte. De même, les deux modules de déflection formant les déflecteurs latéraux peuvent être placés de façon symétrique par rapport à l'axe du canal.

Dans ce cas, les deux extrémités du module de déflection peuvent être arrondies ou profilées, chaque extrémité pouvant se trouver en amont par rapport au sens de circulation du fluide de refroidissement, en fonction de l'orientation et de l'emplacement dudit module de déflection dans le canal.

Chaque déflecteur peut être fixé au corps par vissage. Il peut aussi être fixé par un autre procédé (rivetage ou collage).

Chaque déflecteur peut s'étendre sur toute la hauteur du canal.

Les déflecteurs permettent également de renforcer la structure du corps, en particulier la zone amincie de la paroi supérieure.

Le composant électronique est par exemple un transistor de puissance, notamment du type MOSFET, un transistor bipolaire à grille isolée (IGBT, de l'anglais Insulated Gate Bipolar Transistor) ou une diode.

La semelle et les éléments de refroidissement sont par exemple réalisés en aluminium ou en alliage d'aluminium. Ils peuvent être aussi réalisés en un autre matériau dépendant des spécifications du module.

Le fluide de refroidissement est de préférence de l'air. Bien entendu, un fluide caloporteur liquide ou un fluide diphasique peut également être utilisé.

L'ensemble est par exemple utilisé pour assurer le pilotage d'un actionneur ou d'un moteur électronique.

L'invention concerne également un aéronef comportant un ensemble de puissance du type précité.

L'invention concerne par ailleurs une électronique utilisée dans une application avionique comportant une ensemble de puissance du type précité.

L'invention sera mieux comprise et d'autres détails, caractéristiques et avantages de l'invention apparaîtront à la lecture de la description suivante faite à titre d'exemple non limitatif en référence aux dessins annexés.

### BREVE DESCRIPTION DES FIGURES

- la figure 1 est une vue en coupe, de face, d'un ensemble de puissance selon une forme de réalisation de l'invention ;
- la figure 2 est une vue en coupe, de dessus, de l'ensemble de puissance de la figure 1;
- la figure 3 est une vue en perspective d'un module de déflection servant à former les déflecteurs ;
- la figure 4 est une vue en perspective d'un module de puissance ;
- la figure 5 est une vue de face d'un module de puissance ;
- la figure 6 est une vue en perspective du corps ;

### DESCRIPTION DETAILLEE

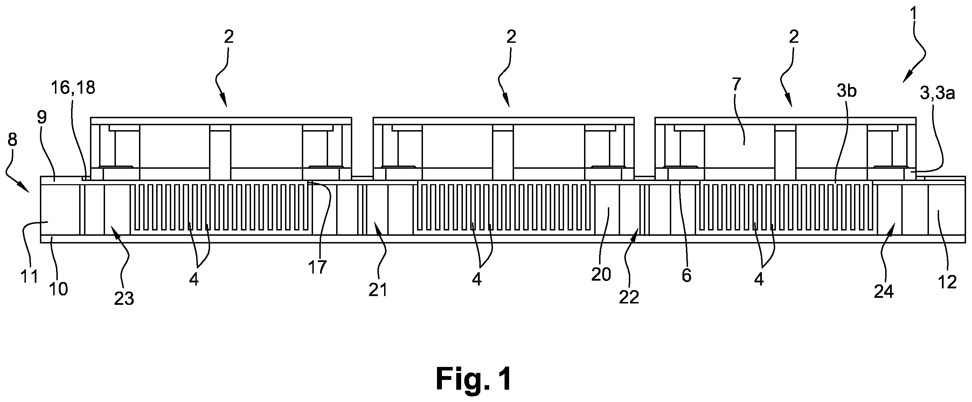

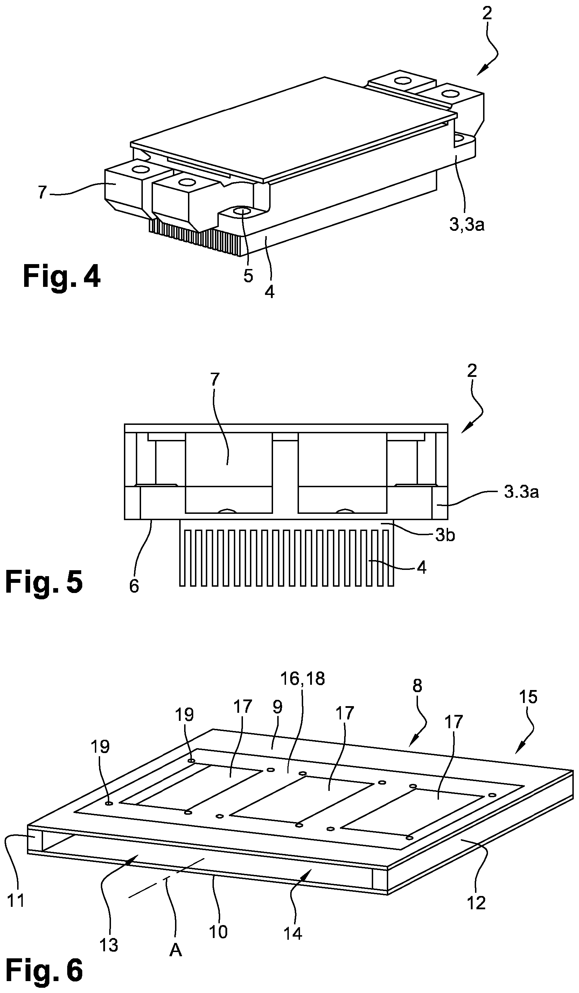

Les figures 1 à 6 illustrent un ensemble de puissance 1 selon une forme de réalisation de l'invention. L'ensemble de puissance 1 comporte des modules de puissance 2, ici trois modules de puissance 2, comportant chacun une semelle 3 présentant une partie dite supérieure 3a et une partie dite inférieure 3b, mieux visible à la figure 5. Les termes supérieur et inférieur sont définis par rapport aux figures. Bien entendu, le module de puissance 2 peut en réalité être placé selon différentes orientations.

Des ailettes 4 s'étendent depuis la partie inférieure de la semelle 3, perpendiculairement par rapport au plan de la semelle 3. Les ailettes 4 sont planes et sont sensiblement parallèles les unes aux autres. Le nombre d'ailettes 4 peut varier en fonction de la largeur des modules, des performances visées, ou encore de la vitesse d'air maximale visée. Les ailettes permettent d'augmenter la surface d'échange d'un facteur variant entre 1 et 50. Elles sont réparties sur toute la largeur du module avec un espacement adapté aux besoins. Les ailettes 4 viennent de matière avec la semelle 3, ces éléments étant par exemple réalisés en aluminium. La semelle 3 comporte des trous de fixation 5 (figure 4) situés par exemple au niveau des coins de la semelle 3.

La partie supérieure 3a de la semelle 3 forme un épaulement délimitant une surface d'appui périphérique 6 (figure 5), entourant la partie inférieure 3b et les ailettes 4.

Le module de puissance 2 comporte en outre des puces électroniques montées sur la semelle 3, par l'intermédiaire d'une interface électriquement isolante, et non visibles sur les figures. Ces puces sont par exemple des transistors de puissance, notamment du type MOSFET, des transistors bipolaires à grille isolée (IGBT, de l'anglais Insulated Gate Bipolar Transistor) ou des diodes. Le module de connexion 2 comporte en outre des moyens de raccordement 7 permettant de raccorder ledit module de puissance 2 à des câbles électriques.

L'ensemble de puissance 1 comporte en outre un corps 8, mieux visible à la figure 6, comportant une paroi supérieure 9, une paroi inférieure 10, une première paroi latérale 11 et une seconde paroi latérale 12. Lesdites parois 9, 10, 11, 12 sont planes. Les parois inférieure 10 et supérieure 9 sont parallèles entre elles. Les parois latérales 11, 12 sont parallèles entre elles et perpendiculaires aux parois inférieure 10 et supérieure 9. Lesdites parois 9, 10, 11, 12 délimitent un canal 13 de section rectangulaire, s'étendant selon un axe A, débouchant à une première extrémité 14, destinée à former une entrée d'air, et à une seconde extrémité 15, destinées à former une sortie d'air.

La paroi supérieure 9 comporte une zone amincie 16. La zone amincie 16 présente par exemple une forme carrée ou rectangulaire. Ladite zone amincie 16 présente par exemple une épaisseur comprise entre 0.5 mm et 3 mm. Le reste de la paroi supérieure 9 présente par exemple une épaisseur comprise entre 1 et 5 mm. L'épaisseur de la zone amincie 16 correspond sensiblement à l'épaisseur de la partie inférieure 3b de la semelle 3.

La zone amincie 16 comporte au moins une ouverture 17, ici trois ouvertures 17, débouchant dans le canal 13. Chaque ouverture 17 présente une forme carrée ou rectangulaire, de forme complémentaire à celle de la partie inférieure 3b de la semelle 3 de façon à éviter une discontinuité de surface importante. Chaque module 2 est monté sur le corps 8 de façon ce que la surface d'appui 6 de la partie supérieure 3b de la semelle 3 soit en appui sur la surface externe 18 de la zone amincie 16 du corps 8. La partie inférieure de la semelle 3 est logée dans l'ouverture correspondante 17 de la zone amincie 16 et les ailettes 4 s'étendent intégralement dans le canal 13 du corps 8. Les ailettes 4 sont orientées parallèlement à l'axe A du canal 13. Les ailettes 4 s'étendent sur toute la hauteur du canal 13. Des vis (non représentées) permettent de fixer la semelle 3 à la paroi supérieure 9 du corps 8, lesdites vis étant introduites dans les trous 5 de la semelle 3 et dans des trous 19 du corps 8.

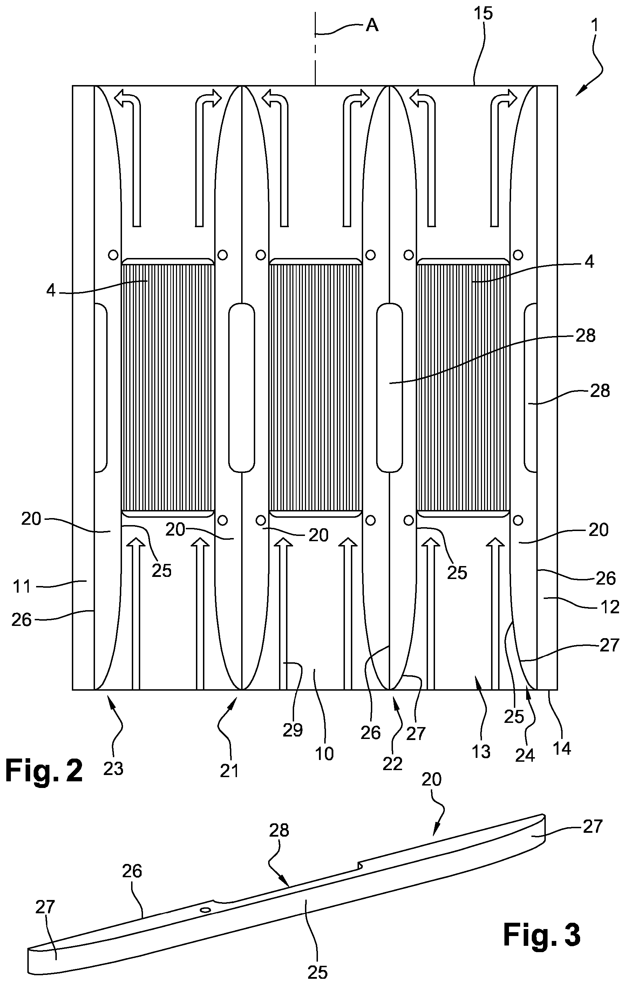

L'ensemble 1 comporte de plus des modules de déflection 20 formant des déflecteurs 21, 22 dits centraux (voir notamment figure 2), en particulier un premier déflecteur 21 central situé entre les ailettes 4 d'un premier module 2 et les ailettes 4 d'un deuxième module 2, et un second déflecteur central 22 situé entre les ailettes 4 du deuxième module et les ailettes 4 d'un troisième module 2, et des déflecteurs latéraux 23, 24. Un premier déflecteur 23 latéral est situé entre les ailettes 4 du premier module 2 et la première paroi latérale 11. Un second déflecteur latéral 24 est situé entre les ailettes 4 du troisième module 2 et la seconde paroi latérale 12. Les déflecteurs 21, 22, 23, 24 sont formés de modules de déflection 20 de même structure. Chaque module de déflection 20 s'étend selon l'axe A du corps 8, comporte un premier bord latéral 25 destiné à être en contact avec de l'air, et un second bord latéral 26. Le premier bord latéral 25 comporte, à chacune de ses extrémités, une zone arrondie, courbée ou profilée 27. Chaque module de déflection 20 comporte en outre une zone évidée 28, débouchant par exemple au niveau du second bord 26 et située ici de façon centrale entre les deux extrémités axiales 27 du module de déflection 20.

Chaque déflecteur central 21, 22 est composé de deux modules de déflection 20 placés de façon symétrique par rapport à l'axe A du canal 13 et côte à côte, de telle sorte que les seconds bords latéraux 26 des deux modules de déflection 20 soient adjacents. Les deux modules de déflection 20 formant les déflecteurs latéraux 23, 24 sont placés de façon symétrique par rapport à l'axe A du canal 13, de telle sorte que les seconds bords latéraux 26 desdits modules de déflection 20 soient en appui sur les surfaces latérales correspondantes 11, 12. Les modules de déflection 20 s'étendent sur toute la hauteur du canal 13, de façon à obstruer complètement les zones concernées du canal 13.

Les modules de déflection 20 sont fixés au corps 8 à l'aide des vis servant également à la fixation des semelles 3 des modules de puissance 2.

Les déflecteurs 21, 22, 23, 24 permettent de renforcer la structure du corps 8, en particulier la zone amincie 16 de la paroi supérieure 9.

En fonctionnement, de l'air de refroidissement 29 est introduit par la première extrémité 14 du canal 13, ou extrémité amont, est scindé de façon homogène en trois parties traversant respectivement les zones pourvues d'ailettes 4 des différents modules de puissance 2. Les dimensions des déflecteurs 21, 22, 23, 24 sont déterminées de façon à combler les espaces laissés libre, soient entre les parois latérales 11, 12 du corps 8 et les zones des modules de puissance 2 adjacents comportant les ailettes 4, soit entre les zones des modules de puissance 2 adjacents comportant les ailettes 4, comme cela est mieux visible à la figure 2. De cette manière, les déflecteurs 21, 22, 23, 24 forcent l'air 29 à passer au travers des différentes zones du canal 13 qui sont pourvues des ailettes 4, favorisant les échanges thermiques entre lesdites ailettes 4 et l'air de refroidissement 29 et donc le refroidissement des modules de puissance 2. L'air 29 est ensuite évacué du canal 13 par la seconde extrémité 15, ou extrémité aval.

## Revendications

1. Ensemble de puissance (1) comportant au moins deux modules de puissance (2) comprenant chacun au moins un composant à refroidir, par exemple une puce électronique, monté sur une semelle (3) à partir de laquelle s'étendent des éléments de refroidissement (4), et un corps creux (8) comportant un canal (13) d'écoulement d'un fluide de refroidissement (29), chaque module de puissance (2) étant monté sur ledit corps (8) de sorte que les éléments de refroidissement (4) s'étendent au moins en partie dans ledit canal (13) au travers d'une ouverture (17) du corps (8), au moins un déflecteur (21, 22, 23, 24) étant monté dans ledit canal (13) entre les éléments de refroidissement (4) des deux modules (2) de façon à forcer le fluide de refroidissement (29) à s'écouler dans la zone du canal (13) comportant les éléments de refroidissement (4), le corps (8) comportant une paroi supérieure (9), une paroi inférieure (10) et deux parois latérales (11, 12) délimitant entre elles le canal (13).

2. Ensemble de puissance (1) selon la revendication 1, **caractérisé en ce que** les éléments de refroidissement (4) sont parallèles entre eux et sont orientés dans la direction (A) du canal (13).

3. Ensemble de puissance (1) selon la revendication 1 ou 2, **caractérisé en ce que** la semelle (3) comporte une partie inférieure (3b) insérée dans l'ouverture (17) du corps (8), les éléments de refroidissement (4) s'étendant depuis une partie inférieure (3b) de la semelle (3).

4. Ensemble de puissance (1) selon la revendication 3, **caractérisé en ce que** la semelle (3) comporte une partie supérieure (3a) formant un épaulement (6) entourant la partie inférieure (3b) de la semelle (3), la partie supérieure (3a) de la semelle (3) venant en appui sur le corps (8).

5. Ensemble de puissance (1) selon les revendications 1 à 4, **caractérisé en ce que** la paroi supérieure (9) comporte une zone amincie (16) dont l'épaisseur correspond sensiblement à l'épaisseur de la partie inférieure (3b) de la semelle (3).

6. Ensemble de puissance (1) selon l'une des revendications 1 à 5, **caractérisé en ce que** le déflecteur (21, 22, 23, 24) s'étend dans la direction (A) du canal (13) et comporte une extrémité amont (27) arrondie ou profilée.

7. Ensemble de puissance (1) selon l'une des revendications 1 à 6, **caractérisé en ce qu'**il comporte au moins un déflecteur central (21, 22), disposé entre les éléments de refroidissement (4) d'un premier module de puissance (2), d'une part, et les éléments de refroidissement (4) d'un deuxième module de puissance (2), d'autre part, un premier déflecteur latéral (23) situé entre les éléments de refroidissement (4) du premier module de puissance (2) et un premier bord latéral (11) du canal (13), et un second déflecteur latéral (24) situé entre les éléments de refroidissement (4) du second module de puissance (2) et un second bord latéral (12) du canal (13).

8. Ensemble de puissance (1) selon la revendication 7, **caractérisé en ce que** le premier déflecteur latéral (23) et le second déflecteur latéral (24) se présentent chacun sous la forme d'un module de déflection (20) de structure unique, le déflecteur central (21, 22) étant composé de deux modules de déflection (20) adjacents.

9. Electronique utilisée dans une application avionique comportant un ensemble de puissance (1) selon l'une des revendications 1 à 8.

## Patentansprüche

1. Leistungsanordnung (1) mit zumindest zwei Leistungsmodulen (2), die jeweils zumindest ein zu kühlendes Bauteil, beispielsweise einen elektronischen Chip, aufweisen, das an einer Grundplatte (3) montiert ist, von der ausgehend sich Kühlelemente (4) erstrecken, und mit einem Hohlkörper (8), der einen Strömungskanal (13) für ein Kühlfluid (29) aufweist, wobei jedes Leistungsmodul (2) so an dem Körper (8) montiert ist, dass sich die Kühlelemente (4) zumindest teilweise in den Kanal (13) durch eine Öffnung (17) des Körpers (8) hindurch erstrecken, wobei zumindest ein Deflektor (21, 22, 23, 24) in dem Kanal (13) zwischen den Kühlelementen (4) der beiden Module (2) montiert ist, so dass das Kühlfluid (29) zwangsweise in den Bereich des Kanals (13) mit den Kühlelementen (4) strömen muss, wobei der Körper (8) eine obere Wand (9), eine Bodenwand (10) und zwei Seitenwände (11, 12) aufweist, die zwischen sich den Kanal (13) begrenzen.

2. Leistungsanordnung (1) nach Anspruch 1,
**dadurch gekennzeichnet, dass** die Kühlelemente (4) parallel zueinander verlaufen und in Richtung (A) des Kanals (13) ausgerichtet sind.

3. Leistungsanordnung (1) nach Anspruch 1 oder 2,
**dadurch gekennzeichnet, dass** die Grundplatte (3) einen unteren Abschnitt (3b) aufweist, der in die Öffnung (17) Körpers (8) eingesetzt ist, wobei sich die Kühlelemente (4) ausgehend von einem unteren Abschnitt (3b) der Grundplatte (3) erstrecken.

4. Leistungsanordnung (1) nach Anspruch 3,
**dadurch gekennzeichnet, dass** die Grundplatte (3) einen oberen Abschnitt (3a) aufweist, der eine Schulter (6) bildet, die den unteren Abschnitt (3b) der Grundplatte (3) umgibt, wobei der obere Abschnitt (3a) der Grundplatte (3) an dem Körper (8) abgestützt ist.

5. Leistungsanordnung (1) nach den Ansprüchen 1 bis 4,
**dadurch gekennzeichnet, dass** die obere Wand (9) einen verjüngten Bereich (16) aufweist, dessen Dicke im Wesentlichen der Dicke des unteren Abschnitts (3b) der Grundplatte (3) entspricht.

6. Leistungsanordnung (1) nach einem der Ansprüche 1 bis 5,
**dadurch gekennzeichnet, dass** sich der Deflektor (21, 22, 23, 24) in Richtung (A) des Kanals (13) erstreckt und ein abgerundetes bzw. profiliertes stromaufwärtiges Ende (27) aufweist.

7. Leistungsanordnung (1) nach einem der Ansprüche 1 bis 6,
**dadurch gekennzeichnet, dass** sie zumindest einen mittigen Deflektor (21, 22), der zwischen den Kühlelementen (4) eines ersten Leistungsmoduls (2) einerseits und den Kühlelementen (4) eines zweiten Leistungsmoduls (2) andererseits angeordnet ist, einen ersten seitlichen Deflektor (23), der zwischen den Kühlelementen (4) des ersten Leistungsmoduls (2) und einer ersten Seitenkante (11) des Kanals (13) angeordnet ist, und einen zweiten seitlichen Deflektor (24), der zwischen den Kühlelementen (4) des zweiten Leistungsmoduls (2) und einer zweiten Seitenkante (12) des Kanals (13) angeordnet ist, umfasst.

8. Leistungsanordnung (1) nach Anspruch 7,
**dadurch gekennzeichnet, dass** der erste seitliche Deflektor (23) und der zweite seitliche Deflektor (24) jeweils als Deflektormodul (20) mit einheitlichem Aufbau ausgebildet sind, wobei der mittige Deflektor (21, 22) aus zwei benachbarten Deflektormodulen (20) besteht.

9. Elektronik zur Verwendung bei Avionikanwendungen, umfassend eine Leistungsanordnung (1) nach einem der Ansprüche 1 bis 8.

## Claims

1. Power unit (1) comprising at least two power modules (2) each comprising at least one component to be cooled, for example an electronic chip, mounted on a sole (3) from which cooling elements (4) extend, and a hollow body (8) comprising a flow channel (13) for a cooling fluid (29), each power module (2) being mounted on said body (8) so that the cooling elements (4) extend at least partly into said channel (13) through an opening (17) in the body (8), at least one deflector (21, 22, 23, 24) being mounted in said channel (13) between the cooling elements (4) of the two modules (2) so as to force the cooling fluid (29) to flow into the area of the channel (13) having the cooling elements (4), the body (8) comprising an upper wall (9), a lower wall (10) and two side walls (11, 12) delimiting the channel (13) between them.

2. Power unit (1) according to claim 1, **characterised in that** the cooling elements (4) are parallel to one another and are oriented in the direction (A) of the channel (13).

3. Power unit (1) according to claims 1 or 2, **characterised in that** the sole (3) has a lower part (3b) inserted into the opening (17) of the body (8), the cooling elements (4) extending from a lower part (3b) of the sole (3).

4. Power unit (1) according to claim 3, **characterised in that** the sole (3) comprises an upper part (3a) forming a shoulder (6) surrounding the lower part (3b) of the sole (3), the upper part (3a) of the sole (3) resting on the body (8).

5. Power unit (1) according to claims 1 to 4, **characterised in that** the upper wall (9) has a thinned zone (16) whose thickness corresponds substantially to the thickness of the lower part (3b) of the sole (3).

6. Power unit (1) according to one of claims 1 to 5, **characterised in that** the deflector (21, 22, 23, 24) extends in the direction (A) of the channel (13) and has a rounded or profiled upstream end (27).

7. Power unit (1) according to one of claims 1 to 6, **characterised in that** it comprises at least one central deflector (21, 22), arranged between the cooling elements (4) of a first power module (2), on the one hand, and the cooling elements (4) of a second power module (2), on the other hand, a first side deflector (23) located between the cooling elements (4) of the first power module (2) and a first side edge (11) of the channel (13), and a second side deflector (24) located between the cooling elements (4) of the second power module (2) and a second side edge (12) of the channel (13).

8. Power unit (1) according to claim 7, **characterised in that** the first side deflector (23) and the second side deflector (24) are each in the form of a deflection module (20) of a single structure, the central deflector (21, 22) being composed of two adjacent deflection modules (20).

9. Electronics used in an avionics application comprising a power unit (1) according to one of claims 1 to 8.
